# EUROPÄISCHE PATENTSCHRIFT

(11) **EP 1 389 344 B1**
(45) Veröffentlichungstag und Bekanntmachung des Hinweises auf die Patenterteilung: **16.07.2014**
(21) Anmeldenummer: 02737846.2
(22) Anmeldetag: 17.05.2002
(51) Int. Cl.: H05K 13/04, H05K 13/02, H05K 13/08, H05K 13/00

(54) **BESTÜCKSYSTEM UND VERFAHREN ZUM BESTÜCKEN VON SUBSTRATEN MIT BAUELEMENTEN**
ASSEMBLY SYSTEM AND METHOD FOR ASSEMBLING COMPONENTS ON SUBSTRATES
SYSTEME ET PROCEDE POUR EQUIPER DES SUBSTRAT AVEC DES COMPOSANTS

(30) Priorität: 23.05.2001 DE 10125392; 23.05.2001 DE 10125391
(43) Veröffentlichungstag der Anmeldung: 18.02.2004
(73) Patentinhaber: ASM Assembly Systems GmbH & Co. KG, 81379 München (DE)
(72) Erfinder: MEHDIANPOUR, Mohammad, 81829 München (DE); SCHULZ, Ralf, 81241 München (DE)
(74) Vertreter: Dilg, Haeusler, Schindelmann Patentanwaltsgesellschaft mbH
(86) Internationale Anmeldenummer: PCT/DE2002/001787
(87) Internationale Veröffentlichungsnummer: WO 2002/095793

(56) Entgegenhaltungen:
- EP-A- 0 302 542
- EP-A1- 1 185 156
- WO-A-01/26440
- DE-U- 29 513 799

## Beschreibung

Die Erfindung betrifft ein Bestücksystem und ein Verfahren zum Bestücken von Substraten mit Bauelementen, wobei die Substrate auf einer im wesentlichen linearen Transportstrecke zuführbar sind und wobei zu beiden Seiten der Transportstrekke jeweils mindestens eine Zuführeinrichtung zum Zuführen von Bauelementen sowie jeweils mindestens ein Bestückfeld mit einer Handhabungsvorrichtung zum Bestücken der zugeführten Bauelemente auf die Substrate angeordnet ist.

Bestücksysteme sind heute zum Bestücken von Substraten mit Bauelementen, insbesondere mit SMD-Bauelementen, weitverbreitet. Die Substrate werden herkömmlicherweise auf einer Transportstrecke zugeführt. Die Bestückfelder sind entlang der Transportstrecke angeordnet. Erreicht ein Substrat ein Bestückfeld, wird seine Position relativ zu einer Handhabungsvorrichtung, welche zum Bestücken der Bauelemente auf die Substrate in dem Bestückfeld angeordnet ist, bestimmt. Danach werden mittels der Handhabungsvorrichtung Bauelemente auf das Substrat bestückt.

Tritt in einem Bestückfeld eines herkömmlichen Bestücksystems ein Fehler auf, welcher das Bestücken in dem Bestückfeld verlangsamt oder zum Erliegen bringt, wird die gesamte Transportstrecke verlangsamt bzw. angehalten. Hierdurch wird die Leistung herkömmlicher Bestücksysteme stark beeinträchtigt.

Das Dokument WO-A-0 126 440 offenbart (siehe auch das nachveröffentlichte Dokument EP-A-1 185 156) ein Bestücksystem zum Bestücken von Substraten mit Bauelementen, wobei die Substrate auf einer im wesentlichen linearen Transportstrecke zuführbar sind, entlang welcher die Substrate im wesentlichen in einer Transportrichtung bewegt werden, und wobei zu beiden Seiten der Transportstrecke jeweils mindestens eine Zuführeinrichtung zum Zuführen von Bauelementen sowie jeweils mindestens ein Bestückfeld mit einer Handhabungsvorrichtung zum Bestücken der zugeführten Bauelemente auf die Substrate angeordnet ist, wobei ein Substrat-Träger-Paar vorgesehen ist, das zwei Substrat-Träger aufweist, von denen jeweils ein Substrat-Träger den Bestückfeldern an einer der beiden Seiten entlang der Transportstrecke zugeordnet ist und jeweils zwischen der Transportstrecke und dem ihm zugeordneten Bestückfeld in einem Bewegungsbereich in einer Bewegungsrichtung des Substrat-Träger-Paares bewegbar ist, und die Bestückfelder eines Substrat-Träger-Paares zueinander bezüglich der Transportstrecke in der Bewegungsrichtung des Substrat-Träger-Paares beabstandet angeordnet sind.

Der Erfindung liegt die Aufgabe zugrunde, ein Bestücksystem und ein Verfahren zum Bestücken von Substraten mit Bauelementen anzugeben, bei welchem die Bestückleistung erhöht ist und das gegenüber Fehlern unempfindlich ist.

Die Aufgabe wird gelöst durch ein Bestücksystem mit den Merkmalen nach Anspruch 1 sowie ein Verfahren zum Bestücken von Substraten mit Bauelementen mit den Merkmalen nach Anspruch 16. Bevorzugte Ausgestaltungen der Erfindung sind in den abhängigen Ansprüchen beansprucht.

Durch das Bestücksystem nach Anspruch 1 ist es möglich, zu beiden Seiten einer Transportstrecke jeweils ein Bestückfeld vorzusehen, in welchem ein Substrat mit Bauelementen bestückt werden kann. Die Substrate werden mittels Substat-Träger-Paaren zwischen der Transportstrecke und den Bestückfeldern bewegt. Ein Substrat-Träger-Paar weist zwei Substrat-Träger auf. Jeweils einer der beiden Substrat-Träger ist einem Bestückfeld auf einer Seite der Transportstrecke zugeordnet. Die Substrat-Träger eines Substrat-Träger-Paares haben eine gemeinsame Bewegungsrichtung, entlang welcher die Bestückfelder voneinander beabstandet angeordnet sind. Die Bewegungsrichtung weist zu der Transportrichtung der Transportstrecke einen Winkel auf, insbesondere ist sie rechtwinkelig hierzu.

Mit dem erfindungsgemäßen Bestücksystem ist es möglich, entlang einer Transportstrecke zugeführte Substrate seitlich der Transportstrecke zu Bestückfeldern zu bewegen, welche beiderseits der Transportstrecke angeordnet sind. Beispielsweise wird ein Substrat mit einem Substrat-Träger eines Substrat-Träger-Paares von der Transportstrecke zu einem Bestückfeld transportiert. Während das Substrat dort bestückt wird, ist es mit dem erfindungsgemäßen Bestücksystem möglich, mittels des anderen Substrat-Trägers des Substrat-Träger-Paares Substrate entlang der Transportstrecke an jenem Bestückfeld vorbeizuschleusen, an welchem das eine Substrat bestückt wird. Es ist auch möglich, mittels des anderen Substrat-Trägers des Substrat-Träger-Paares ein weiteres Substrat dem anderen Bestückfeld auf der anderen Seite der Transportstrecke zuzuführen. Erfindungsgemäß ist hiermit sichergestellt, dass auch bei einem Fehler innerhalb eines Bestückfeldes, welcher bei herkömmlichen Vorrichtungen zum Stillstand der Transportstrecke führen würde, erfindungsgemäß entlang der Transportstrecke weiterhin Substrate transportiert werden können. Hierdurch ist die Leistung und die Betriebssicherheit des erfindungsgemäßen Bestücksystems erhöht.

Die Bewegungsbereiche der Substrat-Träger jedes Substrat-Träger-Paares überlappen sich im Bereich der Transportstrecke. Hierdurch wird ermöglicht, dass ohne zusätzliche Übergabeeinrichtung die Substrate direkt von der Transportstrecke an die Substrat-Träger übergeben werden können. Es wird eine noch höhere Durchlaufgeschwindigkeit erreicht.

Es ist auch möglich, zwei Substrat-Träger-Paare, ein erstes Substrat-Träger-Paar und ein zweites Substrat-Träger-Paar, in der Transportrichtung hintereinander anzuordnen. Hierdurch ist es möglich, jeweils einem Bestückfeld zwei Substrat-Träger zuzuordnen. Dies dient der Reduzierung von Nebenzeiten, da ein einziges Bestückfeld mittels zwei Substrat-Trägern mit Substraten versorgt werden kann. Während ein Substrat bestückt wird, kann das andere Substrat gewechselt werden.

Ferner ist es möglich, eine Ladevorrichtung vorzusehen. Die Ladevorrichtung weist eine Ruheposition auf, welche in der Transportrichtung vor den Substrat-Träger-Paaren liegt. Mittels der Ladevorrichtung können entlang der Transportstrecke zugeführte Substrate in der Transportrichtung bzw. entlang der Transportstrecke zu den Substrat-Träger-Paaren bewegt werden. Dies vereinfacht insbesondere das Zuführen von Substraten zu dem in Transportrichtung der Substrate zweiten Substrat-Träger-Paar. Sind die Substrat-Träger des ersten Substrat-Träger-Paares zu den jeweiligen Bestückfeldern bewegt, entstünde sonst ein Zwischenraum zwischen der Transportstrecke und dem Bewegungsbereich des zweiten Substrat-Träger-Paares. Dieser kann jedoch mittels der Ladevorrichtung überbrückt werden. Hierzu wird von der Transportstrecke ein Substrat an die Ladevorrichtung übergeben. Die Ladevorrichtung wird in der Transportrichtung zu dem zweiten Substrat-Träger-Paar bewegt und kann das Substrat an einen Substrat-Träger des zweiten Substrat-Träger-Paares übergeben, von welchem es zu dem anderen Bestückfeld bewegt werden kann. Es wird hierdurch eine höhere Flexibilität des Bestücksystems ermöglicht.

Außerdem ist es mittels der Ladevorrichtung möglich, Substrate zu einem nachfolgenden Bestücksystem weiterzuleiten, während an dem einen Bestücksystem an allen Bestückfeldern bestückt wird. Hierzu wird ein der Ladevorrichtung übergebenes Substrat mittels der Ladevorrichtung über alle Bewegungsbereiche der Substrat-Träger-Paare hinwegbewegt und der Transportstrecke eines in der Transportrichtung nachfolgenden Bestücksystems übergeben.

Analog hierzu kann auch eine Entladevorrichtung vorgesehen sein, welche entlang der Transportstrecke bewegbar ist und deren Ruhepostition in der Transportrichtung nach den Substrat-Träger-Paaren liegt. Auch mittels der Entladevorrichtung ist es möglich, Substrate von der Transportstrecke aus über die Bewegungsbereiche der Substrat-Träger-Paare hinweg zu der Transportstrecke eines in der Transportrichtung nachfolgenden Bestücksystems zu übergeben. Außerdem ist es mit der Entladevorrichtung möglich, von einem Substrat-Träger eines Substrat-Träger-Paares ein Substrat zu übernehmen und beispielsweise an die Transportstrecke eines in der Transportrichtung nachfolgenden Bestücksystems zu übergeben.

Die Ladevorrichtung bzw. die Entladevorrichtung sind beispielsweise über der Transportstrecke gelagert. Hierdurch wird erreicht, dass von der Ladevorrichtung bzw. der Entladevorrichtung und von den Substrat-Trägern entlang der Transportstrecke derselbe Bewegungsbereich genutzt werden kann, da die Substrat-Träger insbesondere unterhalb der Transportstrecke bzw. in der Höhe der Transportstrecke gelagert sind.

Die Substrat-Träger können mit Bezugspunkten versehen sein und es kann ein Mess-System zum Ermitteln der Position der Substrate relativ zu den Bezugspunkten vorgesehen sein. Um bei mehreren hintereinander angeordneten Substrat-Träger-Paaren die Positionen aller Substrate auf den jeweiligen Substrat-Trägern bestimmen zu können, kann das Mess-System entlang der Transportstrecke über den Substrat-Trägern bewegbar sein. Hierdurch ist es möglich, die Positionen von Substraten auf allen Substrat-Trägern des Bestücksystems mit nur einem einzigen Mess-System zu bestimmen. Das Messen kann beispielsweise erfolgen, während ein Substrat-Träger von der Transportstrecke weg zu dem Bestückfeld bewegt wird. Als Mess-System kommen insbesondere Kameras in Frage. Mittels einer Auswerteeinheit, welche mit den Kameras gekoppelt ist, wird die Positionsbestimmung der Substrate auf den Substrat-Trägern durchgeführt. Nach einer Weiterbildung der Erfindung ist entlang der Transportstrecke eine Transportvorrichtung angeordnet, welche beispielsweise Transportbänder oder Transportriemen aufweist. Mittels der Transportvorrichtung sind die Substrate in der Transportrichtung zu der Ladevorrichtung hin bzw. zu den Substrat-Trägern hin transportierbar und/oder von der Entladevorrichtung weg bzw. von den Substrat-Trägern weg transportierbar. Die Transportstrecke kann auch jeweils auf den Substrat-Trägern bzw. auf der Ladevorrichtung und/oder der Entladevorrichtung zum Positionieren der Substrate auf den selben ausgebildet sein.

Nach einer weiteren, noch leistungsfähigeren Ausgestaltung der Erfindung ist eine zweite Transportstrecke vorgesehen, welche parallel zu der Transportstrecke verläuft und unmittelbar neben der Transportstrecke angeordnet ist. Analog zur vorgenannten Ausgestaltung der Erfindung sind auch eine zweite Ladevorrichtung und eine zweite Entladevorrichtung entlang der zweiten Transportstrecke vorgesehen. Somit ist es möglich, entlang der beiden Transportstrecken Substrate simultan zuzuführen. Diese werden mittels der Ladevorrichtung bzw. der zweiten Ladevorrichtung den Substrat-Trägern zugeführt. Es ist möglich, mittels beiden Ladevorrichtungen Substrate an die Substrat-Träger beiderseits der Transportstrecke und der zweiten Transportstrecke zuzuführen. Hierzu überlappen sich die Bewegungsbereiche der Substrat-Träger-Paare mit den Bewegungsbereichen der Ladevorrichtungen bzw. der Entladevorrichtungen. Es ist ein flexibles Verteilen der Substrate auf entsprechend freie bzw. leere Substrat-Träger möglich.

Nach einer weiteren Ausgestaltung der Erfindung können die Substrate von einem ersten Bestückfeld mittels der Substrat-Träger und/oder mittels der Substrat-Träger und der Ladevorrichtungen und/oder der Substrat-Träger und der Entladevorrichtungen über die Transportstrecke hinweg zu einem zweiten Bestückfeld bewegt werden. Hierzu wird ein auf einem Substrat-Träger angeordnetes Substrat aus einem ersten Bestückfeld mittels des Substrat-Trägers in den Bereich der Transportstrecke bewegt. Von hier aus kann es beispielsweise an einen benachbart angeordneten weiteren Substrat-Träger übergeben werden, welcher es zu einem zweiten Bestückfeld bewegt.

Je nach Anordnung der Substrat-Träger-Paare entlang der Transportstrecke und nach Anzahl der angeordneten Substrat-Träger-Paare ist es hierbei beispielsweise möglich, Substrate diagonal über die Transportstrecke von einem Bestückfeld zu einem anderen Bestückfeld zu übergeben.

Die Substrate können jedoch auch im wesentlichen rechtwinkelig zu der Transportstrecke von einem Bestückfeld zu einem anderen Bestückfeld übergeben werden. Hierdurch ist es möglich, während des Bestückens beispielsweise eine größere Anzahl von unterschiedlichen zu bestückenden Bauelementen auf einem Substrat mit einem einzigen Bestücksystem zu bestücken. Das derart zu bestückende Substrat wird dabei von einem Bestückfeld an ein oder mehrere folgende Bestückfelder übergeben. Da an jedem Bestückfeld eine Mehrzahl von ZuführEinrichtungen vorgesehen ist, an welchen jeweils zu bestükkende Bauelemente vorgesehen sind, ist es möglich, eine sehr große Anzahl unterschiedlicher Bauelemente zum Bestücken auf die Substrate an einem einzigen Bestücksystem bereitzuhalten.

Es ist möglich, mehrere Bestücksysteme zu einer Bestückanlage zusammenzufassen. Dabei können die Bestücksysteme derart angeordnet sein, dass der Bewegungsbereich der Ladevorrichtung von in der Transportrichtung nachfolgend angeordneten Bestücksystemen unmittelbar an den Bewegungsbereich der Substrat-Träger der in der Transportrichtung vorausgehend angeordneten Bestücksysteme angrenzt. Hierbei kann der Bewegungsbereich der Ladevorrichtung, welche zwischen Bestücksystemen angeordnet ist, sich mit den Bewegungsbereichen der Substrat-Träger beider Bestücksysteme überlappen. Dies ermöglicht eine noch flexiblere Verteilung der Substrate auf die einzelnen Substrat-Träger. Je nach dem, ob mit der Bestückanlage eine große Anzahl von unterschiedlichen Bauelementen auf die Substrate bestückt werden soll oder ob eine hohe Anzahl von Substraten parallel gleichzeitig mit einem relativ geringen Bauelemente-Sortiment bestückt werden soll, werden die Substrate entsprechend an ein einziges Bestückfeld der Bestückanlage bzw. an mehreren Bestückfeldern nacheinander bestückt.

Eine andere Ausgestaltung der Bestückanlage sieht vor, mehrere Bestücksysteme derart anzuordnen, dass der Bewegungsbereich der Ladevorrichtungen von in der Transportrichtung nachfolgend angeordneten Bestücksystemen unmittelbar an den Bewegungsbereich der Entladevorrichtungen der in der Transportrichtung vorausgehend angeordneten Bestücksysteme angrenzt. Ähnlich der vorausgehend genannten Bestückanlage ist hier noch zusätzlich eine Entladevorrichtung zwischen den Substrat-Träger-Paaren der einzelnen Bestücksysteme angeordnet. Somit sind aufeinander folgend zwischen den einzelnen Bestücksystemen immer eine Ladevorrichtung und eine Entladevorrichtung angeordnet. Sowohl die Ladevorrichtung als auch die Entladevorrichtung ist in der Transportrichtung bewegbar ausgebildet. Daher stehen bei dieser Ausgestaltung der Erfindung zwischen den einzelnen Bestücksystemen jeweils zwei in der Transportrichtung bewegbare Puffer zur Verfügung.

Durch die Erfindung wird auch ein Verfahren zum Bestücken von Substraten mit Bauelementen geschaffen. Die Bauelemente werden auf einer im wesentlichen linearen Transportstrecke zugeführt. Beiderseits der Transportstrecke ist jeweils mindestens eine Zuführeinrichtung zum Zuführen von Bauelementen sowie jeweils mindestens ein Bestückfeld mit einer Handhabungsvorrichtung zum Bestücken der zugeführten Bauelemente auf die Substrate angeordnet. Die Substrate werden mittels mindestens eines Substrat-Träger-Paares, das zwei Substrat-Träger aufweist, von der Transportstrecke aus in einen Bewegungsbereich in einer Bewegungsrichtung der Substrat-Träger zu den Bestückfeldern beiderseits der Transportstrecke bewegt, wobei sich der Bewegungsbereich der Substrat-Träger mit der Transportstrecke überlappt. An den Bestückfeldern werden die Substrate durch die Handhabungseinrichtungen mit den Bauelementen bestückt.

Durch Bewegen der Substrate mittels eines Substrat-Träger-Paares, das eine einzige Bewegungsrichtung aufweist, entlang welcher die Substrat-Träger in ihrem Bewegungsbereich bewegt werden können, ist es möglich, an einer Stelle der Transportstrecke mittels zwei Substrat-Trägern Substrate sowohl zu einem Bestückfeld an einer Seite der Transportstrecke, wie auch zu einem Bestückfeld an der anderen Seite der Transportstrecke zu transportieren. Hierbei kann beispielsweise auf unterschiedliche Verarbeitungsgeschwindigkeiten beim Bestücken an den einzelnen Bestückfeldern Rücksicht genommen werden und eine optimierte Verteilung der Substrate auf die Bestückfelder vorgenommen werden.

Die Substrate können auch mittels einer Ladevorrichtung, welche entlang der Transportstrecke bewegbar ist und deren Ruheposition in der Transportrichtung vor den Substrat-Trägern liegt, von einer Übernahmeposition an der Ruheposition der Ladevorrichtung zu einer Übergabeposition bewegt werden. Die Übernahmeposition liegt insbesondere vor der Ruheposition der Ladevorrichtung und die Übergabepostion liegt in der Transportrichtung nach den Substrat-Trägern. Hierdurch ist es bei vollständiger Auslastung oder bei einem aufgetretenen Fehler an den Bestückfeldern möglich, Substrate in der Transportrichtung durchzureichen, wodurch ein Stillstand einer aus mehreren Bestücksystemen bestehenden Bestückanlage vermieden wird.

Für das Durchreichen kann zusätzlich noch eine Entladevorrichtung verwendet werden. Die Entladevorrichtung ist zum Entnehmen von Substraten von den Substrat-Trägern vorgesehen und entlang der Transportstrecke bewegbar. Die Ruheposition der Entladevorrichtung liegt in der Transportrichtung nach den Substrat-Trägern. Für ein Durchreichen der Substrate werden die Ladevorrichtung und die Entladevorrichtung direkt von der Übernahmeposition bzw. der Übergabeposition in jeweils eine Zwischenposition bewegt. Die Entladevorrichtung wird direkt von der Zwischenposition in die Übergabeposition bewegt. Dabei befindet sich die Zwischenposition in der Transportrichtung im Bereich der Substrat-Träger.

Ein von der Ladevorrichtung an der Übernahmeposition aufgenommenes Substrat wird mittels der Ladevorrichtung zu der Zwischenposition verbracht und dort kann es von der Entladevorrichtung in die Übergabeposition bewegt werden. Insbesondere können die Ladevorrichtung und die Entladevorrichtung dabei jeweils um die Hälfte des Abstands zwischen der Ladevorrichtung und der Entladevorrichtung aufeinander zubewegt werden, um das Substrat von der Ladevorrichtung an die Entladevorrichtung übergeben zu können. Hierdurch wird ein noch schnelleres Durchreichen eines Substrates über den Bereich der Substrat-Träger hinweg ermöglicht.

Nach einer weiteren Ausgestaltung der Erfindung ist es möglich, mittels eines Mess-Systems die Position der Substrate relativ zu Bezugspunkten auf den Substrat-Trägern zu bestimmen, während die Substrate von den Substrat-Trägern zu den Bestückfeldern bewegt werden. Das Mess-System ist dabei über der Transportstrecke angeordnet und entlang der Transportstrecke bewegbar. Somit kann das Mess-System zum Bestimmen der Position eines Substrates auf einem Substrat-Träger entlang der Transportstrecke über den Bewegungsbereich des entsprechenden Substrat-Trägers bewegt werden. Nach dem Übergeben des Substrates an den Substrat-Träger wird der Substrat-Träger winkelig zu der Transportstrecke zu dem entsprechenden Bestückfeld bewegt. Während dieser Bewegung durchlaufen das Substrat und die Bezugspunkte auf dem Substrat-Träger das Erfassungsfeld des Mess-Systems. Dadurch ist ein schnelles Bestimmen der Position der Substrate relativ zu den Bezugspunkten auf den Substrat-Trägern möglich.

Die Erfindung wird unter Bezugnahme auf bevorzugte Ausführungsformen anhand der Zeichnung näher erläutert. In der Zeichnung zeigen:
Figur 1 einen schematischen seitlichen Schnitt einer bevorzugten Ausführungsform der Erfindung und
Figur 2 einen schematischen Schnitt in Draufsicht der bevorzugten Ausführungsform.

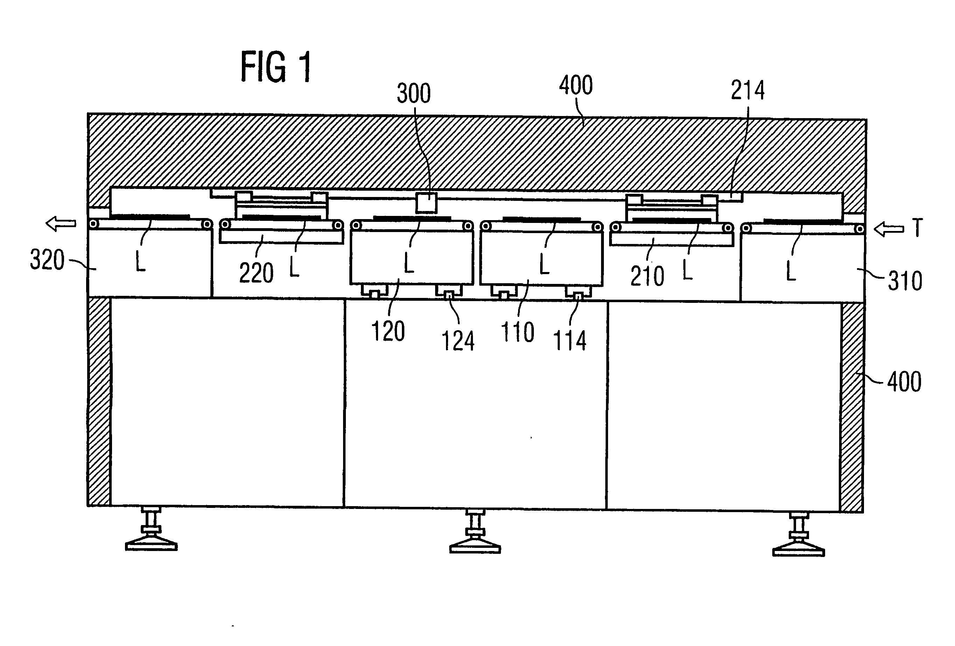

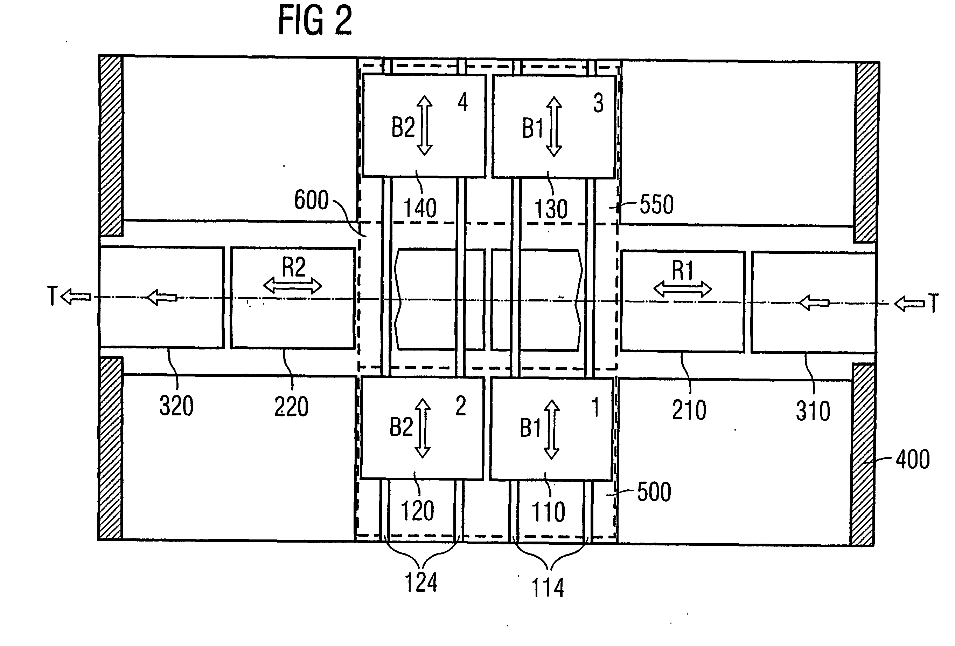

Aus den Figuren 1 und 2 ist eine bevorzugte Ausführungsform des erfindungsgemäßen Bestücksystems ersichtlich. Dabei weist ein Chassis 400 einen im wesentlichen rechteckigen Grundriss auf. Entlang der Längserstreckung des Chassis 400 verläuft eine Transportstrecke entlang der Transportrichtung T. Entlang der Transportstrecke werden Substrate, vorzugsweise Leiterplatten, dem Bestücksystem zugeführt bzw. von diesem abgeführt. Das Zuführen von Leiterplatten L erfolgt vorzugsweise an einer Eingabestation 310, welche eine Übernahmeposition aufweist.

Um die Leiterplatten L transportieren zu können, ist die Eingabestation 310 beispielsweise mit Transportriemen versehen. In der Transportrichtung T nachfolgend der Eingabestation 310 ist eine Ladevorrichtung 210 angeordnet. Von der Eingabestation 310 können Leiterplatten L an die Ladevorrichtung 210 übergeben werden. Die Ladevorrichtung 210 kann beispielsweise Transportriemen zum Transportieren der Leiterplatten L aufweisen.

Die Ladevorrichtung 210 ist an einer stabartigen Führungseinrichtung 214 gelagert, welche an dem Chassis 400 über der Transportstrecke und sich entlang der Transportstrecke erstreckend ausgebildet ist. An der Führungseinrichtung 214 ist auch ein Mess-System 300, insbesondere einer Kamera, angeordnet und entlang der Transportstrecke bewegbar. Die Ladevorrichtung 210 ist, wie aus Figur 2 ersichtlich, entlang der Transportstrecke bewegbar. Beispielsweise kann die Ladevorrichtung von ihrer aus den Figuren 1 und 2 ersichtlichen Ruheposition aus innerhalb eines zentralen Überlappungsbereiches 600 bewegt werden.

Quer zu der Transportrichtung T sind in der Transportrichtung nach der Ruheposition der Ladevorrichtung 210 zwei Führungseinrichtungen 114 bzw. 124 angeordnet. Jede Führungseinrichtung ist mit einem Substrat-Träger-Paar 110, 130 bzw. 120, 140 versehen. Jedes Substrat-Träger-Paar weist zwei Substrat-Träger 110 und 130 bzw. 120 und 140 auf. Die Substrat-Träger 110, 130, 120, 140 sind auf der Führungseinrichtung 114 bzw. 124 winkelig zu der Transportrichtung T bewegbar. Jeder Substrat-Träger kann dabei innerhalb des zentralen Überlappungsbereiches 600 sowie in einem ersten Bestückfeld 500 und einem zweiten Bestückfeld 550 bewegt werden.

In der Transportrichtung den Führungseinrichtungen 114 und 124 ist nachfolgend eine Entladevorrichtung 220 vorgesehen, die eine Übergabeposition aufweist. Die Entladevorrichtung 220 ist analog der Ladevorrichtung 210 aufgebaut und ebenfalls an der Führungseinrichtung 214 angeordnet. Die Entladevorrichtung kann ebenfalls von ihrer Ruheposition aus in dem gesamten zentralen Überlappungsbereich 600 entlang der Transportstrecke bewegt werden. Nachfolgend der Entladevorrichtung 220 ist eine Ausgabestation 320 angeordnet. Die Ausgabestation 320 ist analog der Eingabestation 310 aufgebaut.

Sowohl die Substrat-Träger als auch die Ladevorrichtung 210 und die Entladevorrichtung 220 des erfindungsgemäßen Bestücksystems können mit Transportriemen (nicht gezeigt) versehen sein, um Leiterplatten L darauf bewegen zu können. Das erste Bestückfeld 500 und das zweite Bestückfeld 550 sind jeweils zu einer Seite der Transportstrecke angeordnet. Die Substrat-Träger sowie die Entladevorrichtung 220 und die Ladevorrichtung 210 können beispielsweise mittels Führungselementen entlang der ihrer jeweiligen Führungseinrichtungen 124 bzw. 114 geführt sein. Die Führungselemente sind insbesondere Linear-Lager.

Im folgenden wird der Ablauf der Bestückungsoperationen näher erläutert, die mit der vorliegenden Vorrichtung ausgeführt werden.

Entlang der Transportstrecke wird beispielsweise eine Leiterplatte L einer Eingabestation 310 zur Verfügung gestellt. Die Ladevorrichtung 210 wird in einer Laderichtung R1 entlang der Transportstrecke bewegt, bis die Ladevorrichtung 210 in ihrer Ruheposition angelangt ist. In diesem Zustand kann die Leiterplatte L von der Eingabestation 310 an die Ladevorrichtung 210 übergeben werden, beispielsweise durch Transportieren der Leiterplatte mittels der Transportriemen, welche auf der Ladevorrichtung 210 und auf der Eingabestation 310 vorgesehen sind.

Die Leiterplatte L kann anschließend an eine von vier Leiterplattenpositionen 1, 2, 3 bzw. 4 bewegt werden. Um die Leiterplatte an eine der Leiterplattenpositionen 1 oder 3 zu bewegen, verbleibt die Ladevorrichtung 210 in ihrer Ruheposition. Einer der beiden Substrat-Träger 110 und 130 wird in einer ersten Bewegungsrichtung B1 in den zentralen Überlappungsbereich 600 bewegt, so dass auf dem Substrat-Träger angeordnete Transportriemen mit den Transportriemen der Ladevorrichtung 210 fluchten. Anschließend kann die Leiterplatte L an den Substrat-Träger 110 bzw. 130 übergeben werden.

Soll die Leiterplatte L an einen der beiden den ersten Substrat-Trägern 110 oder 130 nachfolgend angeordneten Substrat-Trägern 120 und 140 des zweiten Substrat-Träger-Paares übergeben werden, das heißt, an die Leiterplattenposition 2 bzw. an die Leiterplattenposition 4 bewegt werden, so wird die Ladevorrichtung 210 in der Laderichtung R1 in etwa hälftig in den zentralen Überlappungsbereich 600 bewegt. Einer der beiden Substrat-Träger 120 und 140 des zweiten Substrat-Träger-Paares wird ebenfalls in den zentralen Überlappungsbereich 600 bewegt, d. h. in einer zweiten Bewegungseinrichtung B2 verfahren. Die Transportriemen des Substrat-Trägers 120 bzw. 140 und der Ladevorrichtung 210 müssen miteinander fluchten, so dass die Leiterplatte L von der Ladevorrichtung 210 an den Substrat-Träger 120 oder 140 des zweiten Substrat-Träger-Paares übergeben werden kann. Anschließend wird der Substrat-Träger 120 bzw. 140 in das erste Bestückfeld 500 bzw. das zweite Bestückfeld 550 in der zweiten Bewegungsrichtung B2 verfahren.

Leiterplatten L, welche auf einem der Substrat-Träger in dem ersten Bestückfeld 500 bzw. in dem zweiten Bestückfeld 550 angeordnet sind, werden mittels einer Handhabungseinrichtung sowie mittels Zuführmodulen, von welchen Bauelemente den Handhabungseinrichtungen zugeführt werden, bestückt. Vor dem Bestücken erfolgt noch ein Vermessen der Leiterplatten L, welche auf einem der Substrat-Träger 110, 130, 120 und 140 angeordnet sind. Hierzu wird das Mess-System 300 entlang der Führungseinrichtung 214 innerhalb des zentralen Überlappungsbereichs 600 über denjenigen Substrat-Träger verfahren, welcher die Leiterplatte L trägt. Der Substrat-Träger befindet sich ohnehin zum Übergeben der Leiterplatte L von der Ladevorrichtung 210 in dem zentralen Überlappungsbereich 600. Wird der Substrat-Träger aus dem zentralen Überlappungsbereich 600 in das erste Bestückfeld 500 oder das zweite Bestückfeld 550 entlang der ersten Bewegungsrichtung B1 oder der zweiten Bewegungsrichtung B2 bewegt, so durchlaufen alle für das Bestimmen der Position der Leiterplatte L auf dem Substrat-Träger 110, 130, 120 bzw. 140 erforderlichen Bezugspunkte sowie die Leiterplatte L das Gesichtsfeld des Mess-Systems 300. Daher ist es möglich, die Position der Leiterplatte L auf dem Substrat-Träger zu bestimmen, ohne dass hierfür zusätzliche Verarbeitungszeit erforderlich ist, da das Bestimmen der Position während des Bewegens des entsprechenden Substrat-Trägers in das erste Bestückfeld 500 bzw. das zweite Bestückfeld 550 erfolgen kann.

Es ist möglich, gleichzeitig in beiden Bestückfeldern 500 und 550 zu bestücken.

Im Bereich um die Bestückfelder 500 bzw. 550 sind die ZuführEinrichtungen angeordnet, von welchen die Bauelemente den Handhabungseinrichtungen zugeführt werden. Um eine möglichst große Vielfalt an unterschiedlichen Bauelementen bereitstellen zu können, kann es erforderlich sein, eine zu bestückende Leiterplatte von einem Bestückfeld zu einem anderen Bestückfeld zu bewegen, um die mögliche Anzahl unterschiedlicher Bauelemente voll ausnutzen zu können.

Hierzu kann eine beispielsweise auf dem Substrat-Träger 110 in der Leiterplattenposition 1 angeordnete Leiterplatte von dem Substrat-Träger 110 in den zentralen Überlappungsbereich 600 bewegt werden. Die Leiterplatte soll beispielsweise auf den Substrat-Träger 140 und an die Leiterplattenposition 4 verbracht werden. Der Substrat-Träger 140 wird daher ebenfalls entlang der zweiten Bewegungsrichtung B2 in den zentralen Überlappungsbereich derart bewegt, dass die Transportriemen der beiden Substrat-Träger 110 und 140 miteinander fluchten. Anschließend wird die Leiterplatte L von dem Substrat-Träger 110 an den Substrat-Träger 140 übergeben. Daraufhin wird der Substrat-Träger 140 in das zweite Bestückfeld 550 bewegt, wo die Leiterplatte L in der Leiterplattenposition 4 mit weiteren Bauelementen bestückt werden kann.

Es ist auch möglich, Leiterplatten im wesentlichen entlang einer Bewegungsrichtung B1 oder B2 zu übergeben. Hierzu wird der mit der entsprechenden Leiterplatte versehene Substrat-Träger eines Substrat-Träger-Paares in den zentralen Bewegungsbereich 600 bewegt. Die Leiterplatte L wird anschließend an die Ladevorrichtung 210 oder an die Entladevorrichtung 220, abhängig davon, welche der beiden an den Substrat-Träger in den zentralen Überlappungsbereich angrenzt, übergeben. Anschließend fährt der andere Substrat-Träger des Substrat-Träger-Paares entlang der Führungseinrichtung 114 bzw. 124 in der genannten Bewegungsrichtung B1 oder B2 in den zentralen Überlappungsbereich 600 und übernimmt die Leiterplatte L von der Ladevorrichtung 210 bzw. von der Entladevorrichtung 220. Daraufhin kann die Leiterplatte L auf diesem Substrat-Träger in das andere Bestückfeld verbracht werden.
Durch das Bestücksystem werden beispielsweise die Nebenzeiten für das Bestimmen der Position der Leiterplatte L auf einem Substrat-Träger 110, 130, 120 bzw. 140 sowie die Nebenzeit für das Wechseln eines zu bestückenden Substrats in einem Bestückfeld eliminiert. Da zwei Substrat-Träger-Paare vorgesehen sind, kann immer ein Substrat-Träger mit einer Leiterplatte L versehen sein und bestückt werden, während der andere diesem Bestückfeld zugeordnete Substrat-Träger eine bereits fertig bestückte Leiterplatte L zum Weitertransport in den zentralen Überlappungsbereich 600 bewegen kann, wo sie mittels der Entladevorrichtung 220 von dem Substrat-Träger entnommen und anschließend an der Ausgabestation 320 ausgegeben werden kann. Gleichzeitig kann dieser Substrat-Träger mittels der Ladevorrichtung 210 mit einer neuen zu bestückenden Leiterplatte L versehen werden, welche anschließend wiederum in das Bestückfeld bewegt wird.

Ferner ist es auch möglich, während beispielsweise in beiden Bestückfeldern 500 und 550 bestückt wird oder keine neue Leiterplatte L erforderlich ist, eine Leiterplatte L entlang der Transportstrecke an den beiden Bestückfeldern 500 und 550 vorbei zur Ausgabestation 320 zu bewegen. Hierzu wird eine Leiterplatte L der Ladevorrichtung 210 übergeben. Die Ladevorrichtung 210 wird in der Laderichtung R1 in den zentralen Überlappungsbereich bewegt. Ebenso wird die Entladevorrichtung 220 in der Entladerichtung R2 in den zentralen Überlappungsbereich 600 bewegt, so dass die Ladevorrichtung und die Entladevorrichtung aneinander angrenzen.

Die Leiterplatte L wird von der Ladevorrichtung 210 an die Entladevorrichtung 220 übergeben. Die Entladevorrichtung 220 wird in ihre Ruheposition bewegt und kann von dort die Leiterplatte L an die Ausgabestation 320 übergeben. Somit ist ein Durchschleusen von Leiterplatten L in der Transportrichtung T möglich, während beispielsweise in beiden Bestückfeldern 500 und 550 bestückt wird oder während in einem der Bestückfelder oder in beiden Bestückfeldern Fehler aufgetreten ist. Es ist lediglich erforderlich, dass keiner der Substrat-Träger 110, 130, 120 bzw. 140 sich in dem zentralen Überlappungsbereich 600 befindet.

Es ist auch möglich, sehr große Leiterplatten L auf gleichzeitig zwei Substrat-Trägern anzuordnen. Hierzu werden beide Substrat-Träger, welche einem der Bestückfelder 500 bzw. 550 zugeordnet sind, d. h. die Substrat-Träger 110 und 120 bzw. die Substrat-Träger 130 und 140 mechanisch gekoppelt. Anschließend werden die gekoppelten Substrat-Träger 110, 120 bzw. 130, 140 in den zentralen Überlappungsbereich 600 bewegt. Dort wird ihnen von der Ladevorrichtung 210 eine übergroße Leiterplatte, welche sich auf beide Substrat-Träger 110, 120 bzw. 130, 140 erstreckt, übergeben. Anschließend wird von den mechanisch gekoppelten Substrat-Trägern 110, 120 bzw. 130, 140 die übergroße Leiterplatte in das erste Bestückfeld 500 bzw. das zweite Bestückfeld 550 bewegt. Dort kann die übergroße Leiterplatte bestückt werden und anschließend in analoger Weise mittels den gekoppelten Substrat-Trägern in den zentralen Bewegungsbereich 600 zurückbewegt und mittels der Entladevorrichtung 220 und der Ausgabestation 320 ausgegeben werden.

Es ist ferner möglich, die Führungseinrichtungen 114 und 124 der Substrat-Träger-Paare derart lang auszubilden, dass innerhalb eines Bestückfeldes 550 bzw. 500 in einer Bewegungsrichtung B1 und/oder B2 beide Substrat-Träger 110, 130, bzw. 120, 140 des jeweiligen entlang der Führungseinrichtung 114 bzw. 124 angeordneten Substrat-Träger-Paares Platz finden und demnach bestückt werden können. Dies kann beispielsweise sinnvoll sein, um größere Variationsmöglichkeiten hinsichtlich der Bauteilevielfalt, welche auf einer Leiterplatte L bestückt werden sollen, bereit zu halten. Hierbei kann eine Leiterplatte L entlang einer der Bewegungsrichtungen B1 und B2 von einem der Bestückfelder 500 bzw. 550 in das andere Bestückfeld 550 bzw. 500 bewegt werden, ohne dass eine dort vorhandene Leiterplatte zuvor entfernt werden muss.

## Patentansprüche

1. Bestücksystem zum Bestücken von Substraten mit Bauelementen, wobei die Substrate (L) auf einer im wesentlichen linearen Transportstrecke zuführbar sind, entlang welcher die Substrate im wesentlichen in einer Transportrichtung (T) bewegt werden, und wobei zu beiden Seiten der Transportstrecke jeweils mindestens eine Zuführeinrichtung zum Zuführen von Bauelementen sowie jeweils mindestens ein Bestückfeld (500, 550) mit einer Handhabungsvorrichtung zum Bestücken der zugeführten Bauelemente auf die Substrate angeordnet ist,
wobei
• mindestens ein Substrat-Träger-Paar vorgesehen ist, das zwei Substrat-Träger (110, 130, 120, 140) aufweist, von denen jeweils ein Substrat-Träger (110, 120, 130, 140) den Bestückfeldern (500, 550) an einer der beiden Seiten entlang der Transportstrecke zugeordnet ist und jeweils zwischen der Transportstrecke und dem ihm zugeordneten Bestückfeld (500, 550) in einem Bewegungsbereich in einer Bewegungsrichtung (B1, B2) des Substrat-Träger-Paares bewegbar ist,
• die Bestückfelder (500, 550) eines Substrat-Träger-Paares zueinander bezüglich der Transportstrecke in der Bewegungsrichtung (B1, B2) des Substrat-Träger-Paares beabstandet angeordnet sind,
• sich entlang der Bewegungsrichtung (B1, B2), welche zu der Transportrichtung (T) einen Winkel aufweist, die Bewegungsbereiche der Substrat-Träger (110, 130 bzw. 120, 140) jedes Substrat-Träger-Paares im Bereich der Transportstrecke überlappen, und
• die beiden Substrat-Träger (110, 130 bzw. 120, 140) des Substrat-Träger-Paars auf einer Führungseinrichtung (114 bzw. 124) entlang der gemeinsamen Bewegungsrichtung (B1 bzw. B2) bewegbar sind.

2. Bestücksystem nach Anspruch 1,
**dadurch gekennzeichnet, dass**
• ein erstes Substrat-Träger-Paar und ein zweites Substrat-Träger-Paar in der Transportrichtung (T) hintereinander angeordnet sind.

3. Bestücksystem nach Anspruch 1 bis 2,
**dadurch gekennzeichnet, dass**
• eine Ladevorrichtung (210) vorgesehen ist, welche zum Beladen der Substrat-Träger (110, 130, 120, 140) mit Substraten (L) entlang der Transportstrecke bewegbar ist und deren Ruheposition in der Transportrichtung (T) vor den Substrat-Träger-Paaren liegt.

4. Bestücksystem nach Anspruch 1 bis 3,
**dadurch gekennzeichnet, dass**
• eine Entladevorrichtung (220) vorgesehen ist, welche zum Entladen der Substrate (L) von den Substrat-Trägern (110, 130, 120, 140) entlang der Transportstrecke bewegbar ist und deren Ruheposition in der Transportrichtung (T) nach den Substrat-Träger-Paaren liegt.

5. Bestücksystem nach Anspruch 3 oder 4,
**dadurch gekennzeichnet, dass** die Ladevorrichtung (210) bzw. die Entladevorrichtung (220) über der Transportstrecke gelagert ist.

6. Bestücksystem nach einem der vorangegangenen Ansprüche, **dadurch gekennzeichnet, dass**
• ein Mess-System (300) zum Ermitteln der Position der Substrate (L) relativ zu Bezugspunkten auf den Substrat-Trägern (110, 130, 120, 140) vorgesehen ist, und
• das Mess-System (300) entlang der Transportstrecke über den Substrat-Trägern (110, 130, 120, 140) bewegbar ist.

7. Bestücksystem nach Anspruch 6,
**dadurch gekennzeichnet, dass** das Mess-System (300) über der Transportstrecke gelagert ist.

8. Bestücksystem nach Anspruch 6 oder 7,
**dadurch gekennzeichnet, dass**
• das Mess-System (300) eine Kamera und eine Auswerteeinheit aufweist.

9. Bestücksystem nach einem der vorangegangenen Ansprüche, **da durch gekennzeichnet,** dass
• eine Transportvorrichtung entlang der Transportstrecke angeordnet ist, von welcher die Substrate (L) in der Transportrichtung (T) zu der Ladevorrichtung (210) bzw. zu den Substrat-Trägern (110, 130, 120, 140) hin transportierbar ist, und von welcher die Substrate (L) in der Transportrichtung (T) von der Entladevorrichtung (220) bzw. von den Substrat-Trägern (110, 130, 120, 140) weg transportierbar ist.

10. Bestücksystem nach Anspruch 9,
**dadurch gekennzeichnet, dass**
• die Transportvorrichtung Transportbänder aufweist.

11. Bestücksystem nach einem der vorangegangenen Ansprüche, soweit sie sich auf Ansprüche 3 und 4 rückbeziehen, **dadurch gekennzeichnet, dass**
• eine zweite Transportstrecke vorgesehen ist, welche parallel zu der Transportstrecke verläuft und unmittelbar neben der Transportstrecke angeordnet ist,
• eine zweite Ladevorrichtung analog der Ladevorrichtung (210) und eine zweite Entladevorrichtung analog der Entladevorrichtung (220) entlang der zweiten Transportstrecke vorgesehen sind,
• die Substrate (L) in der Transportrichtung (T) zu und von den Substrat-Trägern (110, 130, 120, 140) an einer der beiden Seiten der Transportstrecke von der zweiten Ladevorrichtung (210) und der zweiten Entladevorrichtung (220) transportierbar sind, und
• die Substrate (L) in der Transportrichtung (T) zu und von den Substrat-Trägern an der anderen der beiden Seiten der Transportstrecke von der Ladevorrichtung (210) und der Entladevorrichtung (220) transportierbar sind.

12. Bestücksystem nach einem der vorangegangenen Ansprüche, **d adurch gekennzeichnet,** dass
• Substrate (L) von einem ersten Bestückfeld (500) mittels der Substrat-Träger (110, 130, 120, 140) oder mittels der Substrat-Träger (110, 130, 120, 140) und der Ladevorrichtungen oder mittels der Substrat-Träger und der Entladevorrichtungen über die Transportstrecke zu einem zweiten Bestückfeld (550) bewegbar sind.

13. Bestücksystem nach Anspruch 12,
**dadurch gekennzeichnet, dass**
• das erste Bestückfeld (500) und das zweite Bestückfeld (550) zueinander bezüglich der Transportstrecke diagonal angeordnet sind.

14. Bestückanlage mit einer Mehrzahl von Bestücksystemen nach einem der Ansprüche 3 bis 13,
**dadurch gekennzeichnet, dass**
• die Bestücksysteme derart angeordnet sind, dass der Bewegungsbereich der Ladevorrichtungen (210) von in der Transportrichtung (T) nachfolgend angeordneten Bestücksystemen unmittelbar an den Bewegungsbereich der Substrat-Träger (110, 130, 120, 140) der in der Transportrichtung (T) vorausgehend angeordneten Bestücksysteme angrenzt.

15. Bestückanlage mit einer Mehrzahl von Bestücksystemen nach einem der Ansprüche 3 bis 13,
**dadurch gekennzeichnet, dass**
• die Bestücksysteme derart angeordnet sind, dass der Bewegungsbereich der Ladevorrichtungen (210) von in der Transportrichtung (T) nachfolgend angeordneten Bestücksystemen unmittelbar an den Bewegungsbereich der Entladevorrichtungen (220) der in der Transportrichtung (T) vorausgehend angeordneten Bestücksysteme angrenzt.

16. Verfahren zum Bestücken von Substraten (L) mit Bauelementen, wobei die Substrate (L) auf einer im wesentlichen linearen Transportstrecke zuführbar sind, entlang welcher die Substrate (L) im wesentlichen in einer Transportrichtung (T) bewegt werden, und wobei zu beiden Seiten der Transportstrecke jeweils mindestens eine Zuführeinrichtung zum Zuführen von Bauelementen sowie jeweils mindestens ein Bestückfeld (500, 550) mit einer Handhabungsvorrichtung zum Bestücken der zugeführten Bauelemente auf die Substrate (L) angeordnet ist,
wobei
• die Substrate (L) mittels mindestens eines Substrat-Träger-Paares, das zwei Substrat-Träger (110, 130, 120,140) aufweist, von der Transportstrecke aus in einem Bewegungsbereich in einer Bewegungsrichtung (B1, B2) der Substrat-Träger (110, 130, 120,140) zu den Bestückfeldern (500, 550) beiderseits der Transportstrecke bewegt werden,
- wobei sich der Bewegungsbereich mit der Transportstrecke überlappt
- wobei weiterhin sich entlang der Bewegungsrichtung (B1, B2), welche zu der Transportrichtung (T) einen Winkel aufweist, die Bewegungsbereiche der Substrat-Träger (110, 130, 120, 140) jedes Substrat-Träger-Paares im Bereich der Transportstrecke überlappen, und
- wobei die beiden Substrat-Träger (110, 130 bzw. 120, 140) des Substrat-Träger-Paars auf einer Führungseinrichtung (114 bzw. 124) entlang der gemeinsamen Bewegungsrichtung (B1 bzw. B2) bewegt werden, und
• die Substrate (L) an den Bestückfeldern (500, 550) auf den Substrat-Trägern (110, 130, 120,140) mittels den Handhabungseinrichtungen bestückt werden.

17. Verfahren nach Anspruch 16, wobei eine Ladevorrichtung (210) zum Beladen der Substrat-Träger (110, 130, 120,140) mit Substraten (L) vorgesehen ist, welche entlang der Transportstrecke bewegbar ist und deren Ruheposition in der Transportrichtung (T) vor den Substrat-Trägern (110, 130, 120,140) liegt,
**dadurch gekennzeichnet, dass**
• für ein Durchreichen der Substrate (L) die Ladevorrichtung (210) direkt von einer Übernahmeposition zu einer Übergabeposition bewegt wird,
• die Übernahmeposition in der Transportrichtung (T) vor den Substrat-Trägern (110, 130, 120, 140) und vor der Ruheposition der Ladevorrichtung (210) angeordnet ist,
• die Übergabeposition in der Transportrichtung (T) nach den Substrat-Trägern (110, 130, 120,140) angeordnet ist.

18. Verfahren nach Anspruch 17, wobei eine Entladevorrichtung (220) zum Entnehmen der Substrate (L) von den Substrat-Trägern (110, 130, 120,140) vorgesehen ist, welche entlang der Transportstrecke bewegbar ist und deren Ruheposition in der Transportrichtung (T) nach den Substrat-Trägern (110, 130, 120,140) liegt,
**dadurch gekennzeichnet, dass**
• für ein Durchreichen der Substrate (L) die Ladevorrichtung (210) direkt von der Übernahmeposition zu einer Zwischenposition bewegt wird,
• die Entladevorrichtung (220) direkt von der Zwischenposition in die Übergabeposition bewegt wird, und
• die Zwischenposition in der Transportrichtung (T) im Bereich der Substrat-Träger (110, 130, 120,140) liegt.

19. Verfahren nach einem der vorangegangenen Ansprüche 16 bis 18, wobei ein Mess-System (300) zum Bestimmen der Position der Substrate (L) relativ zu Bezugspunkten auf den Substrat-Trägern (110, 130, 120,140) vorgesehen ist, welches entlang der Transportstrecke über den Substrat-Trägern (110, 130, 120,140) bewegbar ist,
**dadurch gekennzeichnet, dass**
• das Bestimmen der Position der Substrate (L) mittels des Mess-Systems (300) durchgeführt wird, während die Substrat-Träger (110, 130, 120,140) zu den Bestückfeldern (500, 550) bewegt werden.

20. Verfahren nach einem der vorangegangenen Ansprüche 16 bis 19, wobei mindestens zwei Substrat-Träger-Paare in der Transportrichtung (T) hintereinander angeordnet sind, **dadurch gekennzeichnet, dass**
• von jeweils mindestens zwei Substrat-Trägern (110, 130, 120,140) auf jeder Seite der Transportstrecke Substrate (L) zu einem Bestückfeld (550, 550) auf dieser Seite bewegt werden,
• die Substrat-Träger (110, 130, 120, 140) jeweils alternierend zwischen dem Bestückfeld (500, 550) und der Transportstrecke bewegt werden,
• während ein Substrat (L), das auf einem Substrat-Träger (110, 130, 120,140) angeordnet ist, mittels der Handhabungseinrichtung in dem Bestückfeld (500, 550) bestückt wird, auf einem anderen Substrat-Träger (110, 130, 120,140) ein anderes Substrat (L) im Bereich der Transportstrecke angeordnet, entnommen und/oder zwischen dem Bestückfeld (500, 550) und der Transportstrecke bewegt wird.

## Claims

1. An assembly system for assembling substrates (L) with components, wherein the substrates (L) are feedable on a substantially linear transport roadway along which the substrates (L) are moved substantially along a transport direction (T), and wherein at both sides of the transport roadway there is respectively arranged (i) at least one feeding arrangement for feeding components and as well as (ii) at least one mounting region (500, 550) with a handling device for assembling the fed components onto the substrates (L), wherein
at least one substrate carrier pair is provided, which comprises two substrate carriers (110, 120, 130, 140), wherein respectively one substrate carrier (110, 120, 130, 140) is assigned to the mounting region (500, 550) at one of the two sides along the transport roadway and is respectively movable (i) between the transport roadway and the mounting region (500, 550) which is assigned to the substrate carrier (110, 120, 130, 140) and (ii) within a movement region along a movement direction (B1, B2) of the substrate carrier pair,
the mounting regions (500, 550) of one substrate carrier pair are arranged spaced apart from each other with respect to the transport roadway along the movement direction (B1, B2) of the substrate carrier pair,
the movement regions of the substrate carriers (110, 130 respectively 120, 140) of each substrate carrier pair overlap each other in the region of the transport roadway along the movement direction (B1, B2), which comprises an angle with respect to the transport direction (T), and
the two substrate carriers (110, 130 respectively 120, 140) of the substrate carrier pair are movable on a guiding arrangement (114 respectively 124) along the common transport direction (B1 respectively B2).

2. The assembly system as set forth in claim 1, **characterized in that** a first substrate carrier pair and a second substrate carrier pair are arranged behind each other along the transport direction (T).

3. The assembly system as set forth in claim 1 to 2, **characterized in that**
there is provided a loading device (210), which is movable along the transport roadway for loading the substrate carriers (110, 130, 120, 140) with substrates (L) and which has a rest position being located along the transport direction in front of the substrate carrier pairs.

4. The assembly system as set forth in claim 1 to 3, **characterized in that**
there is provided an unloading device (220), which is movable along the transport roadway for unloading the substrates (L) from the substrate carriers (110, 130, 120, 140) and which has a rest position being located along the transport direction behind the substrate carrier pairs.

5. The assembly system as set forth in claim 3 or 4, **characterized in that** that the loading device (210) respectively the unloading device (220) is supported above the transport roadway.

6. The assembly system as set forth in any one of the preceding claims, **characterized in that**
there is provided a measurement system (300) for determining the position of the substrates (L) in relation to reference points on the substrate carriers (110, 130, 120, 140) and
the measurement system (300) is movable along the transport roadway above the substrate carriers (110, 130, 120, 140).

7. The assembly system as set forth in claim 6, **characterized in that** the measurement system (300) is supported above the transport roadway.

8. The assembly system as set forth in claim 6 or 7, **characterized in that** the measurement system (300) comprises a camera and an evaluation unit.

9. The assembly system as set forth in any one of the preceding claims, **characterized in that**
along the transport roadway there is arranged a transport device by means of which the substrates (L) are transportable along the transport direction (T) towards the loading device (201) respectively towards the substrate carriers (110, 130, 120, 140) and
by means of which the substrates (L) are transportable along the transport direction (T) away from the unloading device (220) respectively away from the substrate carriers (110, 130, 120, 140).

10. The assembly system as set forth in claim 9, **characterized in that** the transport device comprises band-conveyors.

11. The assembly system as set forth in any one of the preceding claims, insofar they refer back to claims 3 and 4, **characterized in that**
there is provided a second transport roadway, which runs parallel to the transport roadway and which is arranged directly next to the transport roadway,
there are provided along the second transport roadway a second loading device analog the loading device (210) and a second unloading device analog the unloading device (220),
the substrates (L) are transportable along the transport direction (T) towards and away from the substrate carriers (110, 130, 120, 140) at one of the two sides of the transport roadway by means of the second loading device (210) and by means of the second unloading device (220), and
the substrates (L) are transportable along the transport direction (T) towards and away from the substrate carriers at the other one of the two sides of the transport roadway by means of the loading device (210) and by means of the unloading device (220).

12. The assembly system as set forth in any one of the preceding claims, **characterized in that**
substrates (L) are movable via the transport roadway from a first assembly region (500) towards a second assembly region (550) by means of the substrate carriers (110, 120, 130, 140) or by means of the substrate carriers (110, 120, 130, 140) and the loading devices or by means of the substrate carriers (110, 120, 130, 140) and the unloading devices.

13. The assembly system as set forth in claim 12, **characterized in that** with respect to the transport roadway the first assembly region (500) and the second assembly region (550) are arranged diagonally with respect to each other.

14. An assembly arrangement comprising
a plurality of assembly systems as set forth in any one of the claims 3 to 13, **characterized in that**
the assembly systems are arranged in such a manner that the movement region of the loading devices (210) of assembly systems being arranged sequentially along the transport direction (T) directly adjoins the movement region of the substrate carriers (110, 120, 130, 140) of the assembly system which along the transport direction (T) is arranged in front.

15. An assembly arrangement comprising
a plurality of assembly systems as set forth in any one of the claims 3 to 13, **characterized in that**
the assembly systems are arranged in such a manner that the movement region of the loading devices (210) of assembly systems being arranged sequentially along the transport direction (T) directly adjoins the movement region of the unloading devices (220) of the assembly system which along the transport direction (T) is arranged in front.

16. A method for assembling substrates (L) with components, wherein the substrates (L) are feedable on a substantially linear transport roadway along which the substrates (L) are moved substantially along a transport direction (T) and wherein at both sides of the transport roadway there is respectively arranged (i) at least one feeding arrangement for feeding components and as well as (ii) at least one mounting region (500, 550) with a handling device for assembling the fed components onto the substrates (L), wherein
the substrates (L) are moved, by means of at least one substrate carrier pair comprising two substrate carriers (110, 120, 130, 140), (i) starting from the transport roadway within a moving region along a transport direction (B1, B2) of the substrate carriers (110, 120, 130, 140) (ii) to the mounting region (500, 550) at both sides of the transport roadway,
- wherein the movement region overlaps with the transport roadway,
- wherein further along the movement direction (B1, B2), which comprises an angle with respect to the transport direction (T), the movement regions of the substrate carriers (110, 130, 120, 140) of each substrate carrier pair overlap each other in the region of the transport roadway, and
- wherein the two substrate carriers (110, 130 respectively 120, 140) of the substrate carrier pair are moved on a guiding arrangement (114 respectively 124) along the common transport direction (B1 respectively B2), and
the substrates (L) at the mounting regions (500, 550) onto the substrate carriers (110, 130, 120, 140) are assembled by means of the handling devices.

17. The method as set forth in claim 16, wherein
there is provided a loading device (210) for loading the substrate carriers (110, 130, 120, 140) with substrates (L), which loading device (210) is movable along the transport roadway and which loading device (210) has a rest position being located along the transport direction in front of the substrate carriers (110, 130, 120, 140), **characterized in that**
for a passing through of the substrates (L) the loading device (210) is moved directly from an absorbing position to a transferring position,
along the transport direction (T) the absorbing position is arranged in front of the substrate carriers (110, 130, 120, 140) and in front of the rest position of the loading device (210),
along the transport direction (T) the transferring position is arranged behind the substrate carriers (110, 130, 120, 140).

18. The method as set forth in claim 17, wherein
there is provided an unloading device (220) for unloading the substrates (L) from the substrate carriers (110, 130, 120, 140), which unloading device (220) is movable along the transport roadway and which unloading device (220) has a rest position being located along the transport direction behind the substrate carriers (110, 130, 120, 140), **characterized in that**
for a passing through of the substrates (L) the loading device (210) is moved directly from an absorbing position to an intermediate position,
the unloading device (220) is moved directly from the intermediate position to the transferring position, and
along the transport direction (T) the intermediate position is located in the region of the substrate carriers (110, 130, 120, 140).

19. The method as set forth in any one of the preceding claims 16 to 18, wherein
there is provided a measurement system (300) for determining the position of the substrates (L) in relation to reference points on the substrate carriers (110, 130, 120, 140), which measurement system (300) is movable along the transport roadway above the substrate carriers (110, 130, 120, 140), **characterized in that**
determining the position of the substrates (L) is carried out by means of the measurement system (300) while the substrate carriers (110, 130, 120, 140) are moved towards the mounting regions (500, 550).

20. The method as set forth in any one of the preceding claims 16 to 19, wherein along the transport direction (T) at least two substrate carrier pairs are arranged one after the other, **characterized in that**
by means of respectively at least two substrate carriers (110, 130, 120, 140) at each side of the transport roadway substrates (L) are moved to a mounting region at this side,
the substrate carriers (110, 130, 120, 140) are respectively moved between the mounting region (500, 550) and the transport roadway in an alternating manner,
while a substrate (L), which is arranged on a substrate carrier (110, 130, 120, 140), is assembled by means of the handling device within the mounting region (500, 550), on another substrate carrier (110, 130, 120, 140) another substrate (L) in the region of the transport roadway is arranged, unloaded and/or moved between the mounting region (500, 550) and the transport roadway.

## Revendications

1. Système d'équipement servant à équiper des substrats avec des composants, sachant que les substrats (L) peuvent être amenés sur une ligne de transport essentiellement linéaire, le long de laquelle les substrats sont déplacés essentiellement dans une direction de transport (T), et sachant que, respectivement au moins un dispositif d'amenée servant à amener des composants ainsi qu'au moins un champ d'équipement (500, 550) pourvu d'un dispositif de manipulation servant à implanter les composants amenés sur les substrats sont disposés de part et d'autre de la ligne de transport,
sachant
- qu'au moins une paire de supports de substrat est prévue, laquelle présente deux supports de substrat (110, 130, 120, 140), dont respectivement un support de substrat (110, 120, 130, 140) est associé aux champs d'équipement (500, 550) au niveau d'un des deux côtés le long de la ligne de transport et peut être déplacé respectivement entre la ligne de transport et le champ d'équipement (500, 550), qui lui est associé, dans une zone de déplacement, dans une direction de déplacement (B1, B2) de la paire de supports de substrat,
- que les champs d'équipement (500, 550) d'une paire de supports de substrat sont disposés de manière espacée par rapport à la ligne de transport dans la direction de déplacement (B1, B2) de la paire de supports de substrat,
- que les zones de déplacement des supports de substrat (110, 130 ou 120, 140) de chaque paire de supports de substrat se chevauchent, le long de la direction de déplacement (B1, B2), laquelle forme un angle par rapport à la direction de transport (T), dans la zone de la ligne de transport, et
- que les deux supports de substrat (110, 130 ou 120, 140) de la paire de supports de substrat peuvent être déplacés le long de la direction commune de déplacement (B1 ou B2) sur un dispositif de guidage (114 ou 124).

2. Système d'équipement selon la revendication 1,
**caractérisé en ce**
- **qu'**une première paire de supports de substrat et une deuxième paire de supports de substrat sont disposées l'une derrière l'autre dans la direction de transport (T).

3. Système d'équipement selon la revendication 1 à 2,
**caractérisé en ce**
- **qu'**un dispositif de chargement (210) est prévu, lequel peut être déplacé le long de la ligne de transport afin de charger les supports de substrats (110, 130, 120, 140) avec des substrats (L) et dont la position de repos se trouve, dans la direction de transport (T), en amont des paires de supports de substrat.

4. Système d'équipement selon la revendication 1 à 3,
**caractérisé en ce**
- **qu'**un dispositif de déchargement (220) est prévu, lequel peut être déplacé le long de la ligne de transport pour décharger les substrats (L) des supports de substrat (110, 130, 120, 140) et dont la position de repos se trouve, dans la direction de transport (T), en aval des paires de supports de substrat.

5. Système d'équipement selon la revendication 3 ou 4,
**caractérisé en ce que** le dispositif de chargement (210) ou le dispositif de déchargement (220) sont logés au-dessus de la ligne de transport.

6. Système d'équipement selon l'une quelconque des revendications précédentes,
**caractérisé en ce**
- **qu'**un système de mesure (300) servant à déterminer la position des substrats (L) par rapport aux points de référence sur les supports de substrat (110, 130, 120, 140) est prévu, et
- en ce que le système de mesure (300) peut être déplacé le long de la ligne de transport au-dessus des supports de substrat (110, 130, 120, 140).

7. Système d'équipement selon la revendication 6, **caractérisé en ce que** le système de mesure (300) est logé au-dessus de la ligne de transport.

8. Système de mesure selon la revendication 6 ou 7,
**caractérisé en ce**
- **que** le système de mesure (300) présente une caméra et une unité d'analyse.

9. Système d'équipement selon l'une quelconque des revendications précédentes, **caractérisé en ce**
- **qu'**un dispositif de transport est disposé le long de la ligne de transport, depuis laquelle les substrats (L) peuvent être transportés, dans la direction de transport (T), en direction du dispositif de chargement (210) ou en direction des supports de substrat (110, 130, 120, 140), et depuis laquelle les substrats (L) peuvent être transportés, dans la direction de transport (T), de manière à s'éloigner du dispositif de déchargement (220) ou des supports de substrat (110, 130, 120, 140).

10. Système d'équipement selon la revendication 9, **caractérisé en ce**
- **que** le dispositif de transport présente des bandes transporteuses.

11. Système d'équipement selon l'une quelconque revendications précédentes, dans la mesure où elles renvoient aux revendications 3 et 4, **caractérisé en ce**
- **qu'**une deuxième ligne de transport est prévue, laquelle s'étend de manière parallèle par rapport à la ligne de transport et est disposée directement à côté de la ligne de transport ;
- **qu'**un deuxième dispositif de chargement similaire au dispositif de chargement (210) et un deuxième dispositif de déchargement similaire au dispositif de déchargement (220) sont prévus le long de la deuxième ligne de transport ;
- **que** les substrats (L) peuvent être transportés, dans la direction de transport (T), en direction des supports de substrat (110, 130, 120, 140) et depuis ces derniers, au niveau de l'un des deux côtés de la ligne de transport, par le deuxième dispositif de chargement (210) et le deuxième dispositif de déchargement (220) ; et
- **que** les substrats (L) peuvent être transportés, dans la direction de transport (T), en direction des supports de substrat et depuis ces derniers, au niveau de l'autre côté de la ligne de transport, par le dispositif de chargement (210) et le dispositif de déchargement (220).

12. Système d'équipement selon l'une quelconque des revendications précédentes, **caractérisé en ce**
- **que** des substrats (L) peuvent être déplacés depuis un premier champ d'équipement (500), au moyen des supports de substrat (110, 130, 120, 140) ou au moyen des supports de substrat (110, 130, 120, 140) et des dispositifs de chargement ou au moyen des supports de substrat et des dispositifs de déchargement, par l'intermédiaire de la ligne de transport, en direction d'un deuxième champ d'équipement (550).

13. Système d'équipement selon la revendication 12, **caractérisé en ce**
- **que** le premier champ d'équipement (500) et le deuxième champ d'équipement (550) sont disposés de manière diagonale l'un par rapport à l'autre par rapport à la ligne de transport.

14. Installation d'équipement pourvue d'une pluralité de systèmes d'équipement selon l'une quelconque des revendications 3 à 13,
**caractérisée en ce**
- **que** les systèmes d'équipement sont disposés de telle manière que la zone de déplacement des dispositifs de chargement (210) des systèmes d'équipement disposés en aval dans la direction de transport (T) est directement adjacente à la zone de déplacement des supports de substrat (110, 130, 120, 140) des systèmes d'équipement disposés en aval dans la direction de transport (T).

15. Installation d'équipement pourvue d'une pluralité de systèmes d'équipement selon l'une quelconque des revendications 3 à 13,
**caractérisée en ce**
- **que** les systèmes d'équipement sont disposés de telle manière que la zone de déplacement des dispositifs de chargement (210) des systèmes d'équipement disposés en aval dans la direction de transport (T) est directement adjacente à la zone de déplacement des dispositifs de déchargement (220) des systèmes d'équipement disposés en amont dans la direction de transport (T).

16. Procédé servant à équiper des substrats (L) avec des composants, sachant que les substrats (L) peuvent être amenés sur une ligne de transport essentiellement linéaire, le long de laquelle les substrats (L) sont déplacés essentiellement dans la direction de transport (T), et sachant que respectivement au moins un dispositif d'amenée servant à amener des composants ainsi que respectivement au moins un champ d'équipement (500, 550) pourvu d'un dispositif de manipulation servant à implanter les composants amenés sur les substrats (L) sont disposés de part et d'autre de la ligne de transport,
sachant
- que les substrats (L) sont déplacés au moyen au moins d'une paire de supports de substrat, qui présente deux supports de substrat (110, 130, 120, 140), depuis la ligne de transport, dans une zone de déplacement dans une direction de déplacement (B1, B2) des supports de substrat (110, 130, 120, 140) en direction des champs d'équipement (500, 550) de part et d'autre de la ligne de transport,
- sachant que la zone de déplacement chevauche la ligne de transport,
- sachant qu'en outre les zones de déplacement des supports de substrat (110, 130, 120, 140) de chaque paire de supports de substrat se chevauchent dans la zone de la ligne de transport le long de la direction de déplacement (B1, B2), laquelle forme un angle par rapport à la direction de transport (T), et
- sachant que les deux supports de substrat (110, 130 ou 120, 140) de la paire de supports de substrat sont déplacés sur un dispositif de guidage (114 ou 124), le long de la direction commune de déplacement (B1 ou B2), et
- que les substrats (L) sont implantés au niveau des champs d'équipement (500, 550) sur les supports de substrat (110, 130, 120, 140) au moyen des dispositifs de manipulation.

17. Procédé selon la revendication 16, sachant qu'un dispositif de chargement (210) est prévu pour charger les supports de substrat (110, 130, 120, 140) avec des substrats (L), lequel dispositif de chargement peut être déplacé le long de la ligne de transport et dont la position de repos se trouve, dans la direction de transport (T), en amont des supports de substrat (110, 130, 120, 140),
**caractérisé en ce**
- **que** le dispositif de chargement (210) est directement déplacé depuis une position de prise en charge vers une position de transfert pour faire passer les substrats (L),
- **que** la position de prise en charge est disposée dans la direction de transport (T) en amont des supports de substrat (110, 130, 120, 140) et en amont de la position de repos du dispositif de chargement (210),
- **que** la position de transfert est disposée, dans la direction de transport (T), en aval des supports de substrat (110, 130, 120, 140).

18. Procédé selon la revendication 17, sachant qu'un dispositif de déchargement (220) est prévu pour prélever les substrats (L) des supports de substrat (110, 130, 120, 140), lequel dispositif de déchargement peut être déplacé le long de la ligne de transport et dont la position de repos se trouve, dans la direction de transport (T), en aval des supports de substrat (110, 130, 120, 140),
**caractérisé en ce**
- **que** le dispositif de chargement (210) est directement déplacé depuis la position de prise en charge vers une position intermédiaire pour faire passer les substrats (L),
- **que** le dispositif de déchargement (220) est directement déplacé depuis la position intermédiaire dans la position de transfert, et
- **que** la position intermédiaire se trouve dans la direction de transport (T) dans la zone des supports de substrat (110, 130, 120, 140).

19. Procédé selon l'une quelconque des revendications précédentes 16 à 18, sachant qu'un système de mesure (300) est prévu pour déterminer la position des substrats (L) par rapport aux points de référence sur les supports de substrat (110, 130, 120, 140), lequel système de mesure peut être déplacé le long de la ligne de transport au-dessus des supports de substrat (110, 130, 120, 140),
**caractérisé en ce**
- **que** la détermination de la position des substrats (L) est effectuée au moyen du système de mesure (300), tandis que les supports de substrat (110, 130, 120, 140) sont déplacés en direction des champs d'équipement (500, 550).

20. Procédé selon l'une quelconque des revendications précédentes 16 à 19, sachant qu'au moins deux paires de supports de substrat sont disposées dans la direction de transport (T) les unes derrière les autres,
**caractérisé en ce**
- **que** des substrats (L), en provenance de respectivement au moins deux supports de substrat (110, 130, 120, 140), sont déplacés, sur chaque côté de la ligne de transport, en direction d'un champ d'équipement (500, 550) sur ledit côté,
- **que** les supports de substrat (110, 130, 120, 140) sont déplacés respectivement en alternance entre le champ d'équipement (500, 550) et la ligne de transport,
- **que**, tandis qu'un substrat (L) disposé sur un support de substrat (110, 130, 120, 140) est implanté dans le champ d'équipement (500, 550) au moyen du dispositif de manipulation, un autre substrat (L) est disposé dans la zone de la ligne de transport, sur un autre support de substrat (110, 130, 120, 140), est prélevé et/ou est déplacé entre le champ d'équipement (500, 550) et la ligne de transport.
